# EUROPEAN PATENT APPLICATION

(11) **EP 4 822 514 A1**
(43) Date of publication of application: **14.10.2026**
(21) Application number: 25169997.1
(22) Date of filing: 11.04.2025
(51) Int. Cl.: G06F 5/01, G06F 5/00, G06F 7/483, G06N 3/063, G06N 20/00, H03M 7/24

(54) **FLOATING-POINT NUMBER FORMAT FOR MACHINE LEARNING**

(71) Applicant: Forschungszentrum Jülich GmbH, 52428 Jülich (DE)
(72) Inventor: RANA, Dr. Vikas, 52428 Jülich (DE); ISSAC, Dr. Tom Glint, 52428 Jülich (DE)
(74) Representative: Gille Hrabal Partnerschaftsgesellschaft mbB Patentanwälte

(57) **Abstract**

The invention relates to a computer-implemented floating-point number format for use in machine learning, an inference method of a machine-learning model, a training method of a machine-learning model, a use of the number format, a computer program, a computer-readable medium, a data carrier, a data carrier signal and an electronic device. A computer-implemented floating-point number format for use in machine learning has an exponent and a mantissa. The exponent is asymmetrically biased.

## Description

The invention relates to a computer-implemented floating-point number format for use in machine learning, an inference method of a machine-learning model, a training method of a machine-learning model, a use of the number format, a computer program, a computer-readable medium, a data carrier, a data carrier signal and an electronic device.

Machine learning uses complex models which require significant computational power. Calculations are based on numbers which are traditionally represented in a floating-point 32-bit number format, for example according to the IEEE 754 standard, which is also known as single-precision floating-point format. This format comprises one sign bit, 8 exponent bits and 24 (or 23) mantissa or significand bits. While being suitable for a large range of numbers and ensuring high precision, this number format becomes a limiting factor due to its inherent latency, energy consumption, storage space and hardware effort.

To overcome these drawbacks, quantized number formats have been developed. For example, different 16-bit formats have been employed, such as the Brain Floating Point 16-bit (bfloat16) or the IEEE 754 Half-Precision (FP16), which use one sign bit and different numbers of exponent bits and mantissa bits, while deploying only half the space. On the other hand, fixed-point representations have been used, which are, however, problematic for deep-learning due to their limitation regarding dynamic range, as they tend to cause problems with activations and gradients which typically span over multiple orders of magnitude. As these quantized number formats provide less information, it is evident that the advantages regarding energy consumption, silicon area requirements and hardware complexity go hand in hand with disadvantages regarding precision.

For example, FP16 format follows the formula $F = {\left(-1\right)}^{S} ∗ \left(1+M\right) ∗ {2}^{\left(E-15\right)} ,$ with F being the number or value to be represented, S being the sign bit, M being the mantissa bit, and E being the exponent bit. The exponent bias is -15, which means that the value stored is offset from the actual value by -15. In the FP16 format, the exponent is stored in the range of 1...30 (0 and 31 have special meanings). The bias of -15 ensures that the exponent is in the range of -14...+15, thus enabling positive and negative exponents without requiring a further sign bit. In general, positive exponents relate to absolute values of the number above 1, while negative exponents relate to absolute values of the number between 0 and 1.

To reduce energy consumption, latency, silicon area and hardware effort even further, 8-bit floating-point (fp8) formats have been developed, using only 5 exponent bits and 2 mantissa bits (E5M2) or 4 exponent bits and 3 mantissa bits (E4M3). However, the small mantissa leads to a significant loss or precision, making this format suitable mainly for inference rather than training. Other formats such as Posit Arithmetic numbers aim at improving precision and dynamic range at a given bit-width using a dynamic regime encoding. However, their dynamic encoding scheme requires higher bit count for flexibility.

The aforementioned definitions and features may be combined individually or in combination with the following aspects, embodiments and features of the invention.

The task of the invention is to provide and, in particular, implement a further developed number format.

The task is solved by the computer-implemented floating-point number format for use in machine learning according to claim 1 as well as an inference method and a training method of a machine-learning model, a use of the number format, a computer program, a computer-readable medium or a data carrier or a data carrier signal and an electronic device according to the additional claims. Advantageous embodiments are defined in the subclaims.

To solve the task, a computer-implemented floating-point number format for use in machine learning has an exponent and a mantissa. In particular, the exponent is asymmetrically biased.

The invention is based on the insight that in machine learning, not all numbers are used in the same frequency. Neural network computations predominantly involve numerical values within a constrained range, with activations, weights, and gradients frequently clustering around small magnitudes. Almost all weight values may be between -1 and +1, for example, or almost all exponents of weight values, when encoded in a floating-point format, are less than zero. It has been shown that the distribution and range of these numbers depend on the model used.

The known symmetric number formats cannot account for the data distribution in machine learning. A large fraction of storage space is wasted, as certain ranges of numbers are not relevant for the specific machine-learning model.

The format according to the invention optimizes representation coverage for neural network training and interference. The range in which neural network weights and activations typically reside can therefore be covered better or with higher precision. This allows for reduced bit-widths, entailing the mentioned advantages regarding energy consumption, latency, silicon area and hardware effort, without compromising precision or performance, and/or to an increased precision without affecting memory requirements.

The exponent is biased, i.e., the exponent has an offset. In other words, the value stored, (exponent E + bias B) is offset from the actual value (exponent E) by a bias (B). In order to output a value, for example, the calculated exponent (E + B) first has to be corrected by subtracting or adding the bias.

The bias or offset is such that the exponent is asymmetrical. In particular, the exponent is asymmetrically biased around zero. In particular, there is a difference of more than 1 between the absolute value of the negative exponent with the maximum absolute value and the absolute value of the positive exponent with the maximum absolute value. Therefore, the numbers above 1 and the numbers between 0 and 1 are encoded with a different precision or resolution.

For example, if the exponent is encoded with 2 bits, there are 4 values which can be stored, 0, 1, 2, and 3. In order to be asymmetrically biased around zero, the bias can by any number except for -1 (which would result in -1, 0, +1, +2, where |-1| = 1 and |2| = 2, thus the difference between the negative exponent with the maximum absolute value is 1) or -2 (which would result in -2, -1, 0, +1, where |-2| = 2 and |1| = 1, where the difference between the negative exponent with the maximum absolute value is also 1).

The number format represents an encoding scheme. Thus, numbers are typically converted into the number format before performing calculations such as during training or inference.

The number-format is a floating-point format having an exponent and a mantissa. If the exponent is positive, the absolute value of the number is above 1. If the exponent is negative, the absolute value of the number is between 0 and 1. Due to the bias, negative exponents can be encoded without requiring an additional sign. In other words, the exponent is stored as an unsigned value, and when being interpreted, it is converted into an exponent within a signed range by adding or subtracting the bias.

The mantissa or significand is the precision of the number. In particular, the mantissa is the fractional portion of the number, preferably after it has been normalized. In the normalized form, the point, in particular binary point, is just to the left of the most significant non-zero digit in particular 1.

In one configuration, the mantissa has an implicit leading 1. Thus, the value of the mantissa does not code the leading 1, but the leading 1 is interpreted during calculation. Thus, one bit is saved for actually needed values. For example, a 2-bit mantissa can therefore have a 3-bit precision. This maximizes representational efficiency.

In particular, the number format further comprises at least one, in particular exactly one sign bit. The sign bit determines the polarity of the number. Typically, 0 is for positive numbers and 1 is for negative numbers.

In particular, the asymmetric bias is such that small magnitudes, in particular small absolute values, are prioritized over greater magnitudes, in particular greater absolute values. In other words, a step width is smaller or a resolution is higher for smaller magnitudes or absolute values in comparison to greater magnitudes or absolute values. Granularity is enhanced for smaller magnitudes.

In particular, the number format is binary. The bias is in particular an integer. The exponent is in particular an integer. The mantissa is in particular an integer.

The number format according to the invention is for use in machine learning. In particular, the number format is for use in a machine-learning model, for example for a calculation operation of a machine-learning model. The machine-learning model may be a neural network such as a convolutional neural network or a large language model, for example. In particular, the machine-learning model is a quantized neural network which is ideal for architectures where numerical precision can be strategically reduced without compromising performance.

In one configuration, the computer-implemented floating-point number format is embodied on a medium and/or as an electromagnetic carrier wave. One aspect of the invention is therefore a medium or an electromagnetic carrier wave carrying a computer-implemented floating-point number format according to the invention. Another aspect is a medium or an electromagnetic carrier wave carrying a value in the computer-implemented floating-point number format according to the invention.

In particular, a value coded in the number format may be a weight value or an activation value, for example. It has been shown that these values are often present in ranges between -1 and +1 which can be particularly well coded using the number format.

The aspects of the invention control a computer's internal functioning and operation, as each calculation is directly influenced by the data format used. In addition, a great part of previously necessary operations can be omitted. Thus, the processor load is significantly reduced. The invention also relates to formats, methods and programs for processing code at low level, as the number format is a basis for all processes, and a great number of values and calculations is not required anymore. This contributes to producing the further technical effect of significantly limiting the resources needed.

In one embodiment, the exponent is biased such that a difference between an absolute value of a negative exponent having the maximum absolute value and an absolute value of a positive exponent having the maximum absolute value is at least 2.

In other words, the absolute value of (exponent E + bias B) for the largest coded exponent minus the absolute value of (exponent E + bias B) for the smallest coded exponent is at least 2. A value of 1 may occur in conventional formats, as there may be an uneven number of values which automatically leads to a difference in absolute values. However, this does not anticipate or teach the present invention.

To the alternative, if the bias is such that only negative or only positive exponents are represented, the exponent is also asymmetrically biased around zero.

In one configuration, the exponent bias is such that only exponents < 0 or only exponents ≤ 0 are represented, in other words, that E + B is < 0 or ≤ 0. The resulting small numbers encoded by the number format are particularly suitable for many machine-learning models.

In one embodiment, the number format has at least two exponent bits. Thus, the exponent is encoded with at least two bits. Thus, there are at least four different exponent values which can be encoded.

In one embodiment, the number format has at least two mantissa bits. Thus, the mantissa is encoded with at least two bits. Thus, there are at least four different mantissa values which can be encoded.

When having two exponent bits and two mantissa bits, the number format has four bits. Thus, there are at least 16 numbers which can be encoded.

It has been shown that the given numbers are minimum numbers to arrive at a certain accuracy which is sufficient and advantageous for most applications. A high precision can be ensured with this embodiment.

In particular, the absolute value of the bias is at most 20, more particularly at most 15, preferably at most 10. In some embodiments, the bias is negative.

In one embodiment, the exponent is biased by -3.

Here, the exponent numbers 0, 1, 2, 3 actually store exponent values of -3, -2, -1, and 0. All exponent values are ≤ 0. Thus, values between -2 and +2, for example, can be represented in particularly high resolution. It has been shown that the bias of -3 is especially suitable for convolutional neural networks (CNN).

In another configuration, the exponent is biased by -7. Thus, the exponent numbers 0, 1, 2, and 3 actually store exponent values of -7, -6, -5, and -4. Here, smaller absolute values between -0.1 and +0.1 can be represented in particularly high resolution, for example. It has been shown that the bias of -7 is especially suitable for large language models (LLM).

In one configuration, the number of exponent bits is at most 8, in particular at most 7, more particularly at most 6, most particularly at most 5. In one embodiment, the number of exponent bits is at most 4, in particular at most 3.

In one configuration, the number of mantissa bits is at most 8, in particular at most 7, more particularly at most 6, most particularly at most 5. In one embodiment, the number of mantissa bits is at most 4, in particular at most 3.

In one embodiment, the number of exponent bits is 2 and/or the number of mantissa bits is 2. Generally, the number of bits refers to the number required for encoding or storing the value in the said format.

It has shown that for machine-learning models, the mentioned reduced number of exponent and/or mantissa bits, down to at most 3 or at most 2 bits, are sufficient for the desired precision. This applies in particular in combination with the asymmetrically-biased exponent, where the number format having 2 mantissa bits and 2 exponent bits has been shown to have the same precision as the conventional floating-point 32-bit number format. Depending on the desired properties, the more exponent and/or mantissa bits can be used.

In general, the adoption of reduced bit-width results in particularly low latency, as multiply-accumulate (MAC) operations become less complex and computational speed increases. Energy efficiency is significantly enhanced due to reduced switching activity and power dissipation. Optimized memory utilization is also achieved, as a lower numerical precision minimizes memory footprint, thereby enabling more efficient model storage and bandwidth usage. In combination with the asymmetrically-biased exponent, energy consumption, latency, silicon area and hardware effort are reduced while ensuring a high precision.

In one embodiment, the number format does not include the bias. Thus, the bias is not represented in the number format, not even in a coded form. Therefore, the bias cannot be derived from a number represented in the number format. The number format does not include any information from which the bias can be derived. Thus, a specific hardware has to be used in which the bias is known or coded. This reduces the space requirement even further.

In one embodiment, the number format is according to the following formula: $F = {\left(-1\right)}^{S} ∗ \left(1+M\right) ∗ {2}^{\left(E+B\right)} ,$ with F being the number or value to be represented or coded, in particular a decimal number, S being the sign, in particular 0 or 1, M being the mantissa, E being the exponent, and B being the bias.

In particular, the mantissa (M) is a decimal number. In particular, the exponent (E) is a decimal number. In particular, the bias (B) is a decimal number.

If the sign bit is 0, the sign expression (-1)*^{S}* becomes 1. On the other hand, if the sign bit is 1, the sign expression becomes -1.

Due to the term "1+", The mantissa expression (1 + M) has an implicit leading 1. Thus, only decimal places are considered.

The bias B is added to the exponent E and the sum E + B is the exponent of the number 2.

In one embodiment, the mantissa is according to the following formula: $M = MSB ∗ {2}^{- 1} + LSB ∗ {2}^{- 2} ,$ with M being the mantissa, in particular as a decimal number, MSB being the most significant bit of the mantissa, in particular of the binary mantissa, and LSB being the least significant bit of the mantissa, in particular of the binary mantissa.

A further aspect of the invention is an inference method of a machine-learning model, in which a calculation is performed using the floating-point number format according to the invention. All embodiments, features and advantages of the number format described above may also apply to the inference method and vice versa. During inference, high workloads may occur which can be handled particularly efficiently using the described number format.

In particular, the method is performed using the machine-learning model, more particularly the trained machine-learning model. In particular, the method further comprises converting at least a number into the number format according to the invention, in particular before performing the calculation and/or converting at least one number from the number format according to the invention into a different number format, in particular a standard number format, in particular after the calculation. In particular, the method comprises inputting information. In particular, the method comprises outputting information. In particular, input information is used for the calculation, in particular after conversion into the number format. In particular, calculated information is output, in particular, after conversion from the number format. In the sense of the invention, inference comprises deployment.

In particular, the machine-learning model comprises a transformation algorithm to scale down a number, for example a sum after an addition. In particular, the method comprises scaling down a number, for example a sum after an addition. This may for example be performed after a multiply-accumulate (MAC) step. This has the effect that the numbers represented by the number format are always within the optimum range. Thus, high precision is ensured while keeping effort low, even when calculating numerous numbers.

A further aspect of the invention is a training method for a machine-learning model, in which a calculation is performed using the floating-point number format according to the invention. All embodiments, features and advantages of the number format and the inference method described above may also apply to the training method and vice versa.

In particular, the method is performed using the machine-learning model. In particular, the training method is used to train the machine-learning model based on specific data to prepare it for inference. The training data used depends on the nature and purpose of the model, among others. The machine-learning model is in particular computer-implemented.

A further aspect of the invention is a use of the number format according to the invention in a machine-learning model. All embodiments, features and advantages of the number format and the methods described above may also apply to the use and vice versa.

A further aspect of the invention is a computer program comprising instructions, which, when executed on a computer, perform a calculation using the floating-point number format according to the invention. In particular, the computer program comprises or is a machine-learning model. All embodiments, features and advantages of the number format, the methods and the use described above may also apply to the computer program and vice versa.

Computer is a broad term. A computer in the sense of the invention is an electronic machine that can be programmed to automatically carry out sequences of arithmetic or logical operations (computation), in particular programs. In particular, the computer comprises at least one processing element, typically a microprocessor, and a computer memory, such as a semiconductor memory chips. A computer can also be referred to as computing unit.

A further aspect of the invention is a computer-readable medium, comprising instructions, which, when executed on a computer, perform a calculation using the floating-point number format according to the invention. A further aspect is a data carrier, comprising instructions, which, when executed on a computer, perform a calculation using the floating-point number format according to the invention. A further aspect is a data carrier signal, comprising instructions, which, when executed on a computer, perform a calculation using the floating-point number format according to the invention. All embodiments, features and advantages of the number format, the methods, the use and the computer program described above may also apply to these aspects and vice versa.

A further aspect of the invention is an electronic device, comprising a processor and a computer program or a processor and a computer-readable medium. The computer program or the computer-readable medium, respectively, comprise instructions which, when executed on the processor, perform a calculation using the floating-point number format according to the invention.

In particular, the electronic device comprises the bias. The bias may be stored in the electronic device, for example coded in software or hardware of the electronic device. The bias may be hardwired or stored/ kept floating using a storage means such as a register. In particular, the bias is stored in the electronic device. Thus, the electronic device is configured to interpret the numbers according to the number format.

In one configuration, the electronic device comprises or is a standalone device and/or an edge AI device. In one configuration, the electronic device is or comprises an embedded system, in particular an embedded machine-learning system. The above-mentioned enhanced energy efficiency and low memory footprint are particularly advantageous for such systems and constrained environments. In particular, the electronic device is or comprises an edge AI system. Further, due to the number format according to the invention, scalability for edge Al is improved, which allows deployment on energy-constrained and/or low-power devices. For example, the electronic device is configured for real-time analytics and/or to control an autonomous system using machine learning.

The electronic device may be an Al accelerator or form part of an Al accelerator. A machine-learning accelerator, also known as a neural processing unit, is a specialized hardware accelerator or computer system designed to accelerate artificial intelligence and machine learning applications. In one configuration the electronic device is a multiply-accumulate (MAC) unit of a machine-learning accelerator.

### Example

In the following, an examplary encoding table is given which represents an example of the number format according to the invention. The number format shown here has 5 bits, namely one sign bit (S), two exponent bits (E) and two mantissa bits (M). In the first column, the binary representation is given for all possible values of the 5-bit format. Columns 2, 3 and 4 give the sign, exponent and mantissa in decimal numbers. Column 5 shows the resulting decimal values.

| **Binary (S E M)** | **Sign (S)** | **Exponent (E)** | **Mantissa (M)** | **Decimal Value** |
|---|---|---|---|---|
| 0 00 00 | 0 | 0 (-3 bias) | 0.00 | +0.125 |
| 0 00 01 | 0 | 0 (-3 bias) | 0.25 | +0.15625 |
| 0 00 10 | 0 | 0 (-3 bias) | 0.50 | +0.1875 |
| 0 00 11 | 0 | 0 (-3 bias) | 0.75 | +0.21875 |
| 0 01 00 | 0 | 1 (-3 bias) | 0.00 | +0.25 |
| 0 01 01 | 0 | 1 (-3 bias) | 0.25 | +0.3125 |
| 0 01 10 | 0 | 1 (-3 bias) | 0.50 | +0.375 |
| 0 01 11 | 0 | 1 (-3 bias) | 0.75 | +0.4375 |
| 0 10 00 | 0 | 2 (-3 bias) | 0.00 | +0.50 |
| 0 10 01 | 0 | 2 (-3 bias) | 0.25 | +0.625 |
| 0 10 10 | 0 | 2 (-3 bias) | 0.50 | +0.75 |
| 0 10 11 | 0 | 2 (-3 bias) | 0.75 | +0.875 |
| 0 11 00 | 0 | 3 (-3 bias) | 0.00 | +1.00 |
| 0 11 01 | 0 | 3 (-3 bias) | 0.25 | +1.25 |
| 0 11 10 | 0 | 3 (-3 bias) | 0.50 | +1.50 |
| 0 11 11 | 0 | 3 (-3 bias) | 0.75 | +1.75 |
| 1 00 00 | 1 | 0 (-3 bias) | 0.00 | -0.125 |
| 1 00 01 | 1 | 0 (-3 bias) | 0.25 | -0.15625 |
| 1 00 10 | 1 | 0 (-3 bias) | 0.50 | -0.1875 |
| 1 00 11 | 1 | 0 (-3 bias) | 0.75 | -0.21875 |
| 1 01 00 | 1 | 1 (-3 bias) | 0.00 | -0.25 |
| 1 01 01 | 1 | 1 (-3 bias) | 0.25 | ⁻0.3125 |
| 1 01 10 | 1 | 1 (-3 bias) | 0.50 | -0.375 |
| 1 01 11 | 1 | 1 (-3 bias) | 0.75 | -0.4375 |
| 1 10 00 | 1 | 2 (-3 bias) | 0.00 | -0.50 |
| 1 10 01 | 1 | 2 (-3 bias) | 0.25 | -0.625 |
| 1 10 10 | 1 | 2 (-3 bias) | 0.50 | -0.75 |
| 1 10 11 | 1 | 2 (-3 bias) | 0.75 | -0.875 |
| 1 11 00 | 1 | 3 (-3 bias) | 0.00 | -1.00 |
| 1 11 01 | 1 | 3 (-3 bias) | 0.25 | -1.25 |
| 1 11 10 | 1 | 3 (-3 bias) | 0.50 | -1.50 |
| 1 11 11 | 1 | 3 (-3 bias) | 0.75 | -1.75 |

This example is especially suitable for numbers between -2 and +2 or between -1.5 and +1.5 or between -1 and +1. Small absolute values are encoded with higher precision than larger absolute values.

In the following, exemplary embodiments of the invention are shown using figures. The features of the figures can be combined individually or in combination with other features. The figures are not limiting.

The figures show:
- Figure 1:: a schematic representation of the number format and an electronic device;
- Figure 2:: a schematic representation of a deep neural network;
- Figure 3:: a histogram of weights;
- Figure 4:: a histogram of exponents of weights;
- Figure 5:: a histogram of biases;
- Figure 6:: a histogram of exponents of biases;
- Figure 7:: a schematic representation of a method; and
- Figure 8:: a computer program, a computer-readable medium, a data carrier, or a data carrier signal.

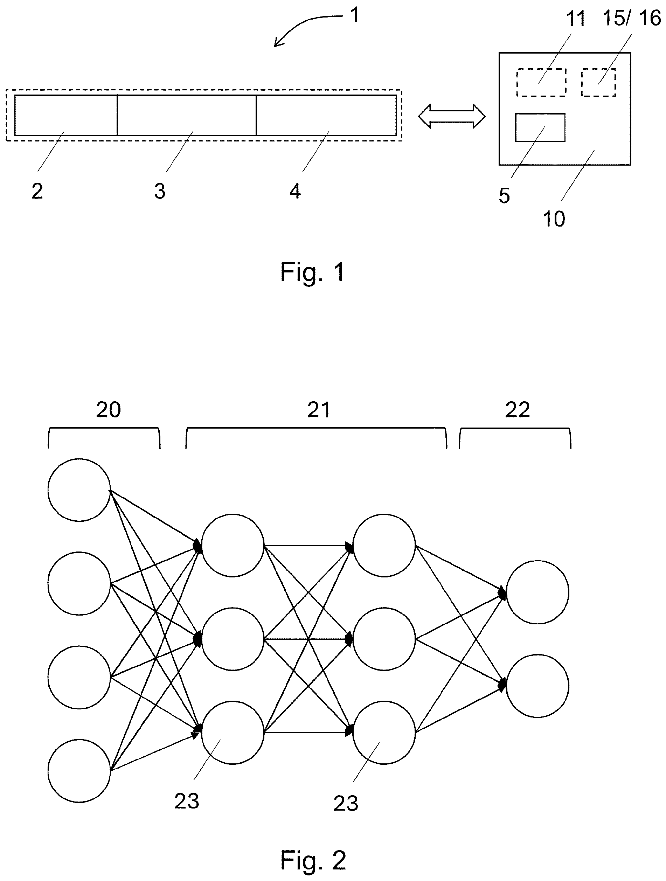

Figure 1 shows on the left-hand side a schematic representation of the computer-implemented floating-point number format 1 according to the invention. The number format 1 comprises a sign 2, a mantissa 3 and an exponent 4. By way of example, the size of the respective fields shows the storage space of the single components. In particular, the sign 2 has 1 bit. In particular, the mantissa 3 has 2 bits. In particular, the exponent 4 has two bits. The exponent 3 is asymmetrically biased using a bias which is preferably not included in the number format 1 itself.

On the right-hand side, an electronic device 10 is schematically shown. In particular, the electronic device 10 interacts with the number format in such a way that calculations are performed by the electronic device 10 using the number format. Preferably, the electronic device includes the bias 5, for example in a hardwired and/or electronically stored way. In this case, an electronic device 10 having the bias 5 is required for interpreting the value stored in the number format.

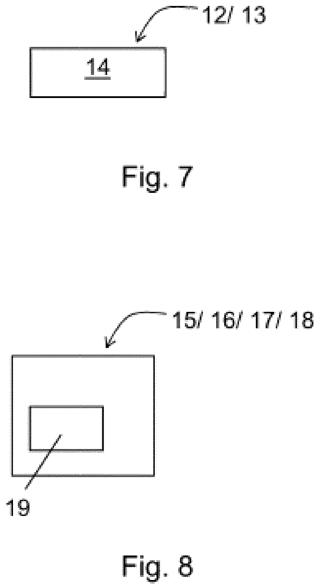

The electronic device 10, which is an individual aspect of the invention, in particular also comprises a processor 11. The electronic device 10 may further comprise a computer program 15 and/or a computer-readable medium 16 comprising instructions, which, when executed on the processor, performs a calculation using the floating-point number format 1. The computer program 15 and the computer-readable medium 16 are also depicted in Figure 8.

Figure 2 shows a simplified schematic of a deep neural network. There is an input layer 20 into which input data or raw data is input. There is a number of hidden layers 21 and there is an output layer 22 through which data is output. By way of example, only two hidden layers 21 are shown. However, deep neural networks usually have far more hidden layers 21, in particular more than hundreds or thousands of hidden layers 21. Each layer 20, 21, 22 comprises artificial neurons 23 which act as nodes. Each circle represents a neuron 23 even though not all circles are marked as such. Neurons 23 apply a transformation of their inputs and pass processed data to the next layer.

Neurons 23 of the input layer 20 correspond to features of the input, such as pixel intensities in an image, words in a sentence of numerical attributes in structured data, for example. In particular, neurons 23 in the hidden layers 21 perform non-linear transformations by applying activation functions to weighed sums of inputs. Deeper networks with multiple hidden layers 21 can extract hierarchical and abstract features from raw data, for example. The output layer 22 produces the desired result depending on the specific task, such as a prediction or classification result. For classification tasks, the output layer typically employs a softmax function to generate probabilities, while for regression tasks, a linear activation function may be used.

The connectivity between neurons is governed by weights, which determine the influence of each input on the neuron's output. Bias terms may also be included to allow for flexible transformations. Weights are adapted or optimized during a learning phase. During forward propagation, for example, input data passes through the network layer by layer. At each neuron 23, a weighed sum of inputs is computed, followed by the application of an activation function. Different activation functions may be used, such as Sigmoid, ReLU (Rectified Linear Unit) or Tanh. In particular, the activation function used introduces non-linearity, thus enabling the network to learn complex mappings.

Loss functions may be used to evaluate network performance. Loss functions quantify the error between the predicted and actual outputs. Once the loss is computed, gradient-based optimization algorithms adjust the weights using back-propagation. This may involve computing gradients of the loss with respect to each weight using the chain rule of differentiation and updating weights.

In particular, a training set of values is used for training, in particular updating model weights through back-propagation. In particular, a validation set is used for validation, in particular for tuning hyperparameters and/or monitoring performance, e.g., to prevent overfitting. In particular, a test set is used to evaluate the final model's performance on different (unseen) data.

Each of the mentioned calculations and functions, alone or in any combination, may be part of any method according to the invention.

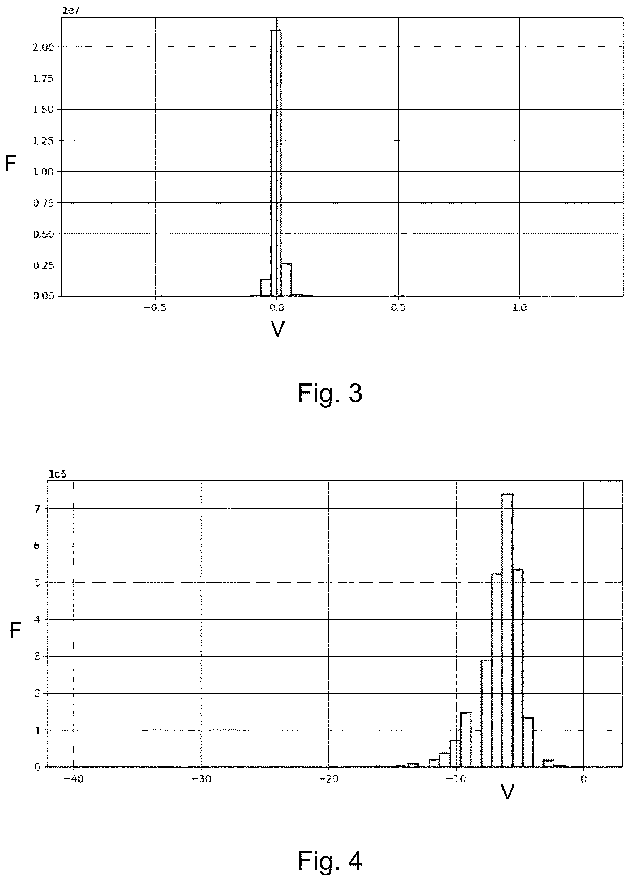

Figure 3 shows a histogram of weight values showing values V according to their frequency F in 10⁷ units. It shows that the values are in the range of -0.2 to +0.2. Smaller values are represented more often than greater values. The maximum frequency is 0.

This shows that a range of -1 to +1 is clearly sufficient to cover the required range. This shows at the same time that the format according to the invention is superior over conventional floating-point formats such as according to IEEE 754 due to the higher precision for small values and that a high precision is not required in larger values.

Convention data formats are largely out of magnitude for deep neural networks.

Figure 4 shows a similar histogram of exponents of weights encoded in a floating-point format. It shows that the exponents are predominantly or entirely less than zero. The maximum frequency is approximately at -6 and the distribution has a negative skewness with minimum values between -15 and -20. Therefore, a biased exponent, here in particular using a negative bias, is suitable to encode the required weights. This shows at the same time that conventional symmetrical floating-point formats are largely out of range for deep neural networks, which diminishes encoding efficiency.

The data shown in Figures 3 and 4 originates from a ResNet50, a widely used Convolutional Neural Network trained on ImageNet. However, it has been shown that the basic findings also apply to other deep neural networks, which diminishes encoding efficiency.

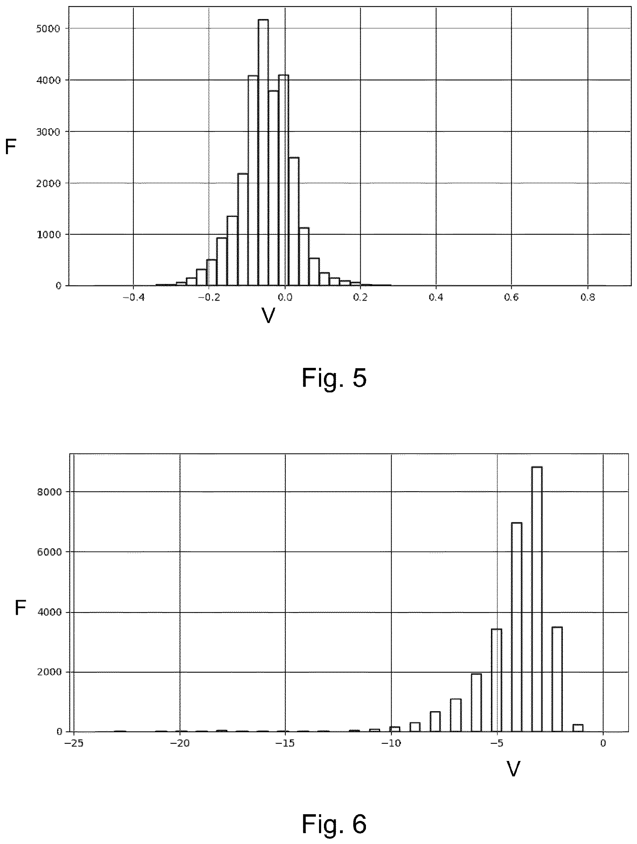

Similarly to Figure 3, Figure 5 shows a histogram of biases showing values V according to their frequency F. In this context, a bias a number which is added to a generated output of a calculation of a neural network, in particular after a convolutional operation. Each initial output element is added with a bias set to form the final output. Thus, in some deep neural networks, the data involved in computation may be (1) output data of the previous layer, (2) weight data of the current layer, (3) bias data (set) of the current layer, which together form the output of the current layer.

Figure 5 shows that the values are in the range of -0.4 to +0.4. Smaller values are represented more often than greater values. The maximum frequency is close to 0, particularly between approx. -0.1 and 0. Also here, a range of -1 to +1 is clearly sufficient to cover the required range.

Similarly to Figure 4, Figure 6 shows a histogram of exponents of biases. The exponents are predominantly or entirely less than zero with a maximum frequency of approx. -3 and a negative skewness.

Figure 7 shows a training method 12 or an inference method 13. Each method 12, 13 only comprises calculation 14, more particularly a step of performing a calculation using the floating-point number format according to the invention. Each method may comprise further steps as described above.

Figure 8 shows a computer program 15, a computer-readable medium 16, a data carrier 17, or a data carrier signal 18, comprising instructions 19 which, when executed on a computer, perform a calculation using the floating-point number format according to the invention.

**List of Reference Signs**

| | |
|---|---|
| Number format | 1 |
| Sign | 2 |
| Exponent | 3 |
| Mantissa | 4 |
| Bias | 5 |
| Electronic device | 10 |
| Processor | 11 |
| Training method | 12 |
| Inference method | 13 |
| Calculation | 14 |
| Computer program | 15 |
| Computer-readable medium | 16 |
| Data carrier | 17 |
| Data carrier signal | 18 |
| Instructions | 19 |
| Input layer | 20 |
| Hidden layer | 21 |
| Output layer | 22 |
| Neuron | 23 |
| Value | V |
| Frequency | F |

## Claims

1. A computer-implemented floating-point number format (1) for use in machine learning, having an exponent (3) and a mantissa (4), **characterized in that** the exponent (3) is asymmetrically biased.

2. The number format (1) of the preceding claim, wherein the exponent (3) is biased such that a difference between an absolute value of a negative exponent (3) having the maximum absolute value and an absolute value of a positive exponent (3) having the maximum absolute value is at least 2.

3. The number format (1) of one of the preceding claims, having at least two exponent (3) bits and/or at least two mantissa (4) bits.

4. The number format (1) of one of claims 1 to 3, wherein the exponent (3) is biased by -3.

5. The number format (1) of one of the preceding claims, wherein the number of exponent (3) bits is at most 4, in particular at most 3, and/or wherein the number of mantissa (4) bits is at most 4, in particular at most 3.

6. The number format (1) of one of the preceding claims, wherein the number of exponent (3) bits is 2 and the number of mantissa (4) bits is 2.

7. The number format (1) of one of the preceding claims, wherein the number format (1) does not include the bias (5).

8. The number format (1) of one of the preceding claims, wherein the number format (1) is according to the following formula: $F = {\left(-1\right)}^{S} ∗ \left(1+M\right) ∗ {2}^{\left(E+B\right)} ,$ with F being the number to be represented, S being a sign (2), M being the mantissa (4), E being the exponent (3), and B being the bias (5).

9. The number format (1) of one of the preceding claims, wherein the mantissa (4) is according to the following formula: $M = MSB ∗ {2}^{- 1} + LSB ∗ {2}^{- 2} ,$ with M being the mantissa (4), MSB being the most significant bit of the mantissa (4) and LSB being the least significant bit of the mantissa (4).

10. An inference method of a machine-learning model, in which a calculation is performed using the floating-point number format (1) according to one of the claims 1 to 9.

11. A training method of a machine-learning model, in which a calculation is performed using the floating-point number format (1) according to one of the claims 1 to 9.

12. A use of the number format (1) according to one of the claims 1 to 9 in a machine-learning model.

13. A computer program (15) comprising instructions (19), which, when executed on a computer, perform a calculation using the floating-point number format (1) according to one of the claims 1 to 9.

14. A computer-readable medium (16) or a data carrier (17) or a data carrier signal (18), comprising instructions (19), which, when executed on a computer, perform a calculation using the floating-point number format (1) according to one of the claims 1 to 9.

15. An electronic device (10), comprising a processor (11) and a computer program (15) or a computer-readable medium (16) comprising instructions (19) which, when executed on the processor, performs a calculation using the floating-point number format (1) according to one of the claims 1 to 9.
